Europäisches Patentamt

European Patent Office

Office européen des brevets

(19)

(11) Publication number: **0 032 887**
**B1**

(12) **EUROPEAN PATENT SPECIFICATION**

(45) Date of publication of patent specification: **23.07.86**

(51) Int. Cl.⁴: **C 23 C 16/30, C 23 C 30/00**

(21) Application number: **81850011.8**

(22) Date of filing: **20.01.81**

(54) Method of preparing coated cemented carbide product and resulting product.

(30) Priority: **21.01.80 US 113751**
**16.04.80 US 140804**

(43) Date of publication of application:
**29.07.81 Bulletin 81/30**

(45) Publication of the grant of the patent:
**23.07.86 Bulletin 86/30**

(84) Designated Contracting States:
**DE FR GB IT SE**

(56) References cited:
**DD-A- 91 956**
**DE-A-2 142 601**
**DE-A-2 323 652**
**GB-A-2 000 815**
**US-A-3 836 392**
**US-A-4 018 631**

**The file contains technical information
submitted after the application was filed and
not included in this specification**

(73) Proprietor: **SANDVIK AKTIEBOLAG**
**S-811 81 Sandviken 1 (SE)**

(72) Inventor: **Kullander, Gregor Henrik**
**Längsjöhöjden 79**
**S-125 31 Älvsjö (SE)**
Inventor: **Chatfield, Christopher George**
**S:t Eriksg. 19**
**S-112 39 Stockholm (SE)**
Inventor: **Mikus, Marian**
**Hällsätrabacken 14I**
**S-127 37 Skärholmen (SE)**
Inventor: **Westergren, Bo Kenneth**
**S:t Mickelsg. 57**
**S-126 54 Hägersten (SE)**

(74) Representative: **Taquist, Lennart et al**
**Sandvik AB Patents & Licences Fack**
**S-811 81 Sandviken 1 (SE)**

Courier Press, Leamington Spa, England.

## Description

The present invention relates to cemented carbide bodies having at least one thin, extremely wear resistant surface layer and to a method of making such products. More particularly, it relates to such coated cemented carbide products in which a layer of aluminum oxide or other wear resistant oxide is firmly bonded to the substrate.

It heretofore was known that an improved wear resistance can be obtained in hard metal (cemented carbide) bodies, for example, cutting inserts, by applying a surface layer of wear resistant oxide upon a substrate of conventional sintered hard metal containing at least one carbide together with a binder metal (see, for example, U.S. Patent Nos. 3,736,107 and 3,836,392). Usually, the thin layer has been applied by deposition from a gaseous phase (e.g., Chemical Vapor Deposition or "CVD" technique), but several other methods have been proposed.

Disturbances from the substrate (and from the material in the reactor vessel, etc.) may obstruct the formation of layers having a satisfactory structure (morphology) and binding ability to the substrate if an oxide layer is applied directly upon the hard metal. Therefore, further development steps have been performed in order to give the products improved properties, suited for the commercial market.

It heretofore was known that desired results could be obtained by the utilization in such composites of different kinds of intermediate layers, for example, one or more layers of carbides, carbonitrides and/or nitrides of Ti, Zr, Hf, V, Nb, Ta, Cr, Mo, W, Si and/or B (see, for example, U.S. Patent No. 3,837,896). In said patent, belonging to the same assignee as the present application, it was noted that neither of the layers contains a binder metal. Other known cemented carbide products consist of laminated layers of different hard metal grades. Such other known cemented carbide products were prepared by conventional pressing and sintering techniques and contained therefore considerable amounts of binder metal (see, for example, British Patent Nos. 1,042,711, 1,115,908 and 1,118,362). Thus, the statement in U.S. Patent 3,837,896 that the coatings should be free from binder metal was not meant to exclude certain inclusions or small contents of mainly Co and W or WC that can be present in the intermediate layer. The essential feature of the invention of U.S. Patent 3,837,896 is that the intermediate layer serves as a barrier to "catch" the mentioned elements, etc., and prevent their diffusion through the layer so that harmful influences upon the oxide layer from these constituents of the substrate can be avoided at the sites of nucleation and/or the growth of the oxide layer. By these means, a coherent and continuous carbide or nitride layer free from binder metal can be obtained at least in a zone immediately below the oxide layer.

It was also known that improved adherence of oxide coatings on cemented carbide substrates could be obtained by a method comprising certain heat treatment and oxidizing steps (see, for example, U.S. Patent 4,018,631). In this method there was a combination of essentially four different steps (I)—(IV):

(I) Forming on the cemented carbide substrate (containing W and Co) a coating comprising a material selected from carbide, nitride, carbonitride and mixtures thereof.

(II) Diffusing W and Co into said coating by heating the product at a temperature greater than the melting point of the Co phase.

(III) Oxidizing said coating.

(IV) Applying an oxide layer.

All these steps were known, either separately or in certain combinations, in connection with coatings on cemented carbide. Thus, the commercial product covered by the earlier mentioned U.S. Patent 3,837,896 is a combination of the steps (I) and (IV). Furthermore, there is mentioned in the specification of said U.S. patent (see, for example, Column 3, lines 52—57) that also the step (III) may be utilized. Finally, the heat treatment of coated cemented carbide at an increased temperature, i.e., step (II), was disclosed in the earlier mentioned U.S. Patent 3,836,392 (see, for example, Column 2, lines 38—45). The said U.S. Patent 3,836,392 was in turn indirectly referred to in the specification, Column 1. lines 25—47, of U.S. Patent 3,837,896, both patents now belonging to the same assignee.

It has now been found that new results can be obtained by a certain combination of some of these known and other known steps as described below. It has now also been found, quite surprisingly, that further, considerable improvements in use and adherence can be achieved if the above mentioned oxidizing step is avoided and the remaining steps (I)+(II)+(IV) are applied together with appropriate additional steps.

The advantages which might be expected from the earlier mentioned known process which includes oxidation of the surface of the coated cemented carbide, would at first sight appear to be a result of the formation of a compound on that surface which is related to the wear resistant oxide applied afterwards. It has been found, however, that the oxidation of the intermediate layer, for example, in the case of a titanium carbide coating, from TiC to TiO, $TiO_2$ or other oxide or oxycarbide (realizing that corresponding compounds containing nitrogen can also be formed if nitrogen is present) causes an expansion of the volume of the layer which can give rise to cracks in the layer. In addition, difficulties arise in the bonding of oxygen in oxides containing titanium to oxygen in oxides containing aluminum. There are, however, different ways of avoiding the mentioned oxidizing step, as will be mentioned in the following, and by these means it is possible to obtain further advantages in the final product.

In accordance with the present invention there is provided a method of treating a cemented carbide substrate containing at least one carbide together with binder metal in order to improve its wear resistance and utility, which method consists essentially of treating the substrate in an atmosphere selected from carbide, nitride and carbonitride forming atmospheres to form or apply a coating essentially consisting of at least one coat of at least one member selected from the group consisting of carbides, nitrides and carbonitrides of the elements Ti, Zr, Hf, V, Nb, Ta, Cr, Mo, W, Si and B; heat treating the coated substrate at a temperature greater than the melting point of the binder phase in order to diffuse elements from the substrate into said coating or from the coating into the substrate; applying a very thin layer of carbide, nitride and/or carbonitride of the earlier mentioned elements applied upon the substrate heated according to steps (a) and (b) as defined in claim 1 and applying a wear resistant oxide coating on the thus pretreated cemented carbide substrate.

The present invention of treating a cemented carbide substrate containing at least one carbide together with binder metal (generally tungsten carbide and cobalt together with other carbides of metals belonging to the groups IVA, VA and VIA of the periodic system if desired as well as possibly other alloying elements) is based upon that the first step (a) in which the substrate is treated in a gaseous atmosphere selected from carbide, nitride and carbonitride forming atmospheres in order to form or apply a surface coating essentially comprising a material selected from carbide, nitride, carbonitride and mixtures thereof of elements selected from Ti, Zr, Hf, V, Nb, Ta, Cr, Mo, W, Si and B and the second step (b) in which the product, i.e., the substrate provided with a coating according to (a), is heat-treated at a temperature exceeding the melting point of a binder metal phase, are performed as one operation. Then, in a third step (c), a wear resistant aluminium oxide layer is applied on the heat-treated (previously coated) substrate of step (b) without any intervening oxidation of the substrate.

The first step (a), by which surface coatings of carbide, nitride or carbonitride (preferably titanium carbide, titanium nitride) are formed or applied, can be performed in several different ways. Besides a usual method which is deposition from a gaseous phase containing metal halide, hydrogen, hydrocarbon and possibly nitrogen (CVD technique), a layer can be applied by pack-cementing and/or resintering. In the last instance, the metal or the hard element (for example TiC) is taken from the substrate. This latter instance is equivalent to the treatment of the substrate according to the steps (a)+(b) as one operation in which the metal or metals forming the actual carbide, nitride and/or carbonitride are diffused from the interior of the substrate to the surface where they are being enriched by using a reactive gas. In this case, the cemented carbide in the substrate has to contain at least some γ (gamma)-phase carbide, i.e., it has to contain at least some of the carbide in the form of a cubic carbide such as TiC, TaC, NbC, etc. Thus, there is obtained a γ (gamma)-phase zone at the surface of the substrate and the application of a surface layer (according to the step (a) and the recrystallization and growth of the grains of the layer (being obtained in the process according to the step (b)) can be substituted by a single process step. Because of said grain growth which is normally obtained, the amount of grain boundaries in the surface layer is reduced and the diffusion of metals as W and Co from the substrate is impeded to a great extent as this diffusion takes place essentially along the grain boundaries.

It has also been found that a surface having a great micro-roughness can be obtained in the last mentioned treatment because of the grain growth and/or the recrystallization, which means an enlarged area of contact and possibilities of "hook-binding" or otherwise adhering the following oxide layer applied according to the step (c) to the substrate.

A method of enriching titanium carbide to the surface of cemented carbide containing (gamma)-phase by packing processes at sintering temperature was, however, known per se (see, for example, U.S. Patent No. 3,564,683, Example 5, in which packing of cemented carbide in TiO₂ and graphite at 1350°C is described). Also other similar processes were known (see, for example, British patent specification 1,506,915) in which a surface layer of carbide was obtained on a cemented carbide body by treatment of the body with carbon monoxide. By said treatment, the concentration of carbide was caused to be greater in the surface layer than within the remainder of the body.

As mentioned earlier, however, it is the special combination of various steps that is essential for obtaining new results, and unexpected, in the final product.

Also the heat treatment, e.g., in a carbon-containing furnace, according to step (b) which is generally conducted in an atmosphere such as vacuum, argon, hydrogen, nitrogen and the like at a temperature above the melting point of the matrix binder metal (in the case of cobalt, a temperature of from about 1200° to 1600°C) for a time sufficient to diffuse the metal from the substrate to the coating (usually from about 5 minutes up to about 3 hours or longer) can preferably be performed at a high temperature within that range such that a certain conversion of the cyrstals in the coating of carbide, etc., is obtained. This increased temperature of diffusion will cause a formation of a micro-rough surface offering the same possibilities and advantages as mentioned in the foregoing.

The surface coating of carbide, etc., according to step (a) can be applied under such circumstances and at such a supersaturation that short whiskers, coarse grains, ellipsoidal plates, etc., of the carbide, etc. are formed. Suitable conditions for formation of whiskers can be obtained at a carefully adjusted, relatively low supersaturation. ("Supersaturation" or over-saturation is present when the initial concentrations or reactants (including reactants (e.g., carbon) coming from the substrate) and products, ordered as in an equilibrium equation, are smaller than the equilibrium concentrations ordered in an analogous way). (See for example "Proceedings of the Conference on Chem. Vap. Dep. of Refr. Metals, Alloys and Compounds" (1967) USA, Page 3). The whiskers should not be so long, however, that the surface of the subsequent oxide layer will be too rough. Oxidizing is avoided by applying the oxide layer at sufficiently reducing conditions. If the oxide layer is applied by means of CVD-technique with $H_2O$ and $H_2$ present in the gaseous phase, the $H_2O/H_2$-ratio in the reaction gas shall be relatively low, generally lower than 0.02 and preferably lower than 0.01 so that all of the oxidizing materials take part in the formation of the oxide layer and do not oxidize the substrate.

In order to clean the hard metal bodies or if a certain amount of the binder metal such as cobalt, or if a tungsten phase has penetrated to the outermost part of the surface layer during the heat treatment, an etching operation can be efficiently utilized. By etching as for example with HCl, possibly in a gaseous phase (in $H_2$), the binder metal is removed. Furthermore, the etching can be effective in the formation of a micro-rough surface. Tungsten and/or tungsten carbide can be removed in a similar way by selective etchants. By the concurrent addition of $H_2$ to the etching gas there is also obtained a reduction of cobalt oxide and tungsten oxide which may possibly be present and whose formation can cause cracking.

The invention is characterized in that a very thin layer of carbide, nitride and/or carbonitride of the earlier mentioned elements is applied upon the substrate heated according to the steps (a)+(b). The layer can, if desired, be of the same material as applied in the step (a) and the treatment is of special interest if this layer and/or layer according to the step (a) has been applied at conditions which produce short whiskers, ellipsoidal plates or coarse grains at the surface which results in a enlarged area of bonding between the carbide, nitride and/or carbonitride and the following oxide layer.

In some cases, in another step, the treatment of step (a) is repeated to provide a further coating. The resulting substrate is then contacted with an atmosphere containing a nitrogen- or sulfur-containing gas to nitride and/or sulfide a portion of the further coating (without oxidizing, etc., the whole of the further coating which causes the said coating to have poor adherence). Thereafter, a wear resistant aluminium oxide layer is applied on the substrate.

The aluminium oxide may be applied to the substrate in accordance with known techniques such as, for example, those set forth in U.S. Patents 3,836,392 and 3,837,896.

In certain instances, an extra strong adherence between the substrate and coating can be obtained by heat-treating the product after applying the aluminium oxide coating, i.e., the substrate, treated according to the steps (a)+(b)+(c), is treated in a further step (d) at a temperature exceeding the melting point of the binder metal phase in the same manner as set forth above for step (b).

When a sufficiently effective bond has been obtained between the substrate, heated according to the steps (a)+(b), and the very thin layer of carbide, nitride and/or carbonitride, for example, between an (inner) TiC-enriched zone of the substrate and a second, outer TiC coating, the substrate is contacted with a nitrogen- or sulfur-containing gas to partially nitride or sulfide the outer (or second) layer.

The treatment of the substrate with a nitrogen- or sulfur-containing gas may be conducted in accordance with conventional techniques. For example, if the treatment of the substrate to provide the second layer is performed in a gaseous phase by a CVD-technique, a gas containing one or more of nitrogen or sulfur or their compounds can be added at the end of or at a period during the coating process and in this way cause said elements to be taken up in the layer in a natural order and without the type of problems obtained when separate layers are applied in succeeding, discrete steps. For example, this structure can be obtained without the kind of cracking found when the layer is oxidized by $CO_2+H_2$ after the coating as proposed in U.S. Patent 4,018,631. The addition of the mentioned elements to the intermediate layer causes an improved adherence to the outer oxide layer.

In particular, very interesting and beneficial results are obtained when the treatment to form the first or second layers is performed without using any chlorine or chlorine compounds in the gaseous phase.

The nitride and/or sulfide partial outer layer may also be applied by nitriding and/or sulfiding the substrate by conventional techniques known in the art.

It is possible to treat the coating with a mixture containing sulfur, e.g., $CS_2+H_2$, which forms a sulfide on the outer layer or a mixture containing nitrogen, e.g., a nitrogen oxide and $H_2$, which forms a nitride on the outer layer.

In addition, the last-mentioned nitriding and/or sulfiding treatment may be applied to the substrate treated as mentioned above in which nitrogen- or sulfur-containing gas is added to the CVD depositing gas of the second layer.

Optionally, another thin coating of carbide, nitride and/or carbonitride can be deposited on top of the last mentioned coating prior to the last alumina coating step and, if desired, sulfur-containing gas may be added to the CVD depositing gas in the same manner as described below.

It is also advantageous to apply by a further step a wear resistant aluminium oxide layer, suitably a relatively thin layer by means of CVD-technique at a temperature around 1000°C. By this step there is obtained a bonding of oxide during the critical CVD nucleation stage, which is particularly desirable in regard to adherence. A CVD-layer (not heat treated) is also more wear resistant than a heat treated CVD layer.

In certain instances, extra strong adherence between the substrate and a coating can be obtained by heat treating the product after applying the second layer (before and/or after it is nitrided or sulfided) in a further step at a temperature exceeding the melting point of the binder metal phase in the same manner as set forth above for step (b). If desired, the substrate, after application of the aluminium oxide coating may also be heat-treated in a similar manner.

It may also be advantageous to apply to the aluminium oxide-coated substrate another layer of a carbide, nitride or carbonitride as described above in regard to the first step and thereafter to apply another aluminium oxide wear resistant layer in the same manner as described above.

It can also be advantageous to add a sulfur- and/or a nitrogen-containing gas at the end of or at a period during the treatment of step (a) to form a sulfide and/or a nitride portion on or in said coating. Thus, when the treatment of the substrate according to the step (a) is performed in a gaseous phase by CVD-technique, a gas containing one or more sulfur- and/or nitrogen-containing compounds is added at the end of or at a period during the coating process and in this way cause the sulfur and/or nitrogen to be taken up in the layer in a natural order. The addition of these elements to the intermediate layer causes a further improved adherence to the outer oxide layer particularly, when the step (a) treatment was performed without using any chlorine or chlorine compounds in the gaseous phase.

The nitride and or sulfide partial outer layer may also be applied by nitriding and/or sulfiding the substrate by conventional techniques known in the art, e.g., utilizing mixtures of $CS_2+H_2$ which forms a sulfide on the outer layer or a mixture containing nitrogen, e.g., a nitrogen oxide and $H_2$, which forms a nitride on the outer layer. This method is especially efficient when especially good protection is sought to prevent cobalt diffusion from the substrate.

In any event, the nitriding or sulfiding of the first layer is performed such that no more than about 70% of the first layer is sulfided or nitrided.

The invention is additionally illustrated in connection with the following Examples which are to be considered as illustrative of the present invention. It should be understood, however, that the invention is not limited to the specific details of the Examples.

Comparative Example a
(Non-inventive art)

300 cemented carbide cutting inserts (type SPUN 120308) are coated with a thin layer of TiC in a conventional CVD pilot plant. The composition of the cemented carbide is in % by weight: 86% WC, 5.5% Co and the remainder cubic carbides (TaC, NbC and TiC). The deposition process is performed at 1030°C and 20 torr; the deposition time is 4 hours. The gas contains 4% $CH_4$ and 4% $TiCl_4$, the remainder being essentially $H_2$. There is obtained a coating of TiC with a thickness of 2 μm.

The coated inserts are then heat treated at 1350°C to 1500°C in a tunnel furnace in hydrogen atmosphere for a time in the heat zone of from about 1 to 3 hours (the shorter times being used for the inserts treated at the higher temperatures). In a final step the inserts are coated with $Al_2O_3$ by treatment in a gaseous phase at a temperature of 1030°C and a pressure of 50 torr. In the gaseous phase 3% $AlCl_3$ is added to a $H_2/CO_2$-mixture adjusted so that the content of $H_2O$ at the inserts is about 0.002% of the content of $H_2$.

The product obtained has the following characteristics according to light microscope examinations:

A 4—5 μm thick $Al_2O_3$ coating (mean average thickness) has been deposited on a micro-rough surface consisting of a 1—2 μm thick zone. Said zone or layer consists essentially of cubic carbides which have a grain size of about 1 μm and contain crystals protruding about 1 μm and having about the same grain size as in the substrate. The bonding between the substrate and the zone of cubic carbides as well as the bonding between said zone and the $Al_2O_3$ coating is excellent. No crack formation between the $Al_2O_3$ coating and the carbide zone can be found.

Comparative Example b
(Non-inventive art)

A number of cemented carbide cutting inserts are treated in the same way as in Comparative Example a—except that the inserts are oxidized for about 0.2 hr in a $CO_2+H_2$-mixture (about 10% $CO_2$) at about 1100°C and atmospheric pressure before the coating with $Al_2O_3$ is performed. The inserts are examined in a light microscope after the $Al_2O_3$ coating treatment. In the inspections, it is found that the interface between the $Al_2O_3$ layer and the oxidized surface of the heat treated substrate is relatively uniform in comparison with the results obtained in Comparative Example a.

In a comparative test using hardness indentations at varying loads the following results are obtained: (Each example gives the result of 3 separate tests. The figure "0" means that no cracking appears and the figure "1" means that cracking is observed).

| Load | Comparative Example a | Comparative Example b |
|------|-----------------------|-----------------------|
| (HRA kg) | | |
| 60 | 000 | 000 |
| 100 | 000 | 010 |
| 150 | 100 | 111 |

Comparative Example c

300 hard metal cutting inserts of different batches (type SPUN 120308) are heated in a HF-heated graphite crucible furnace. The composition of the hard metal is (in % by weight) 86% WC, 5.5% Co and the remainder cubic carbide (TaC, NbC and TiC). The temperature is 1350—1550°C and as protecting gas is used hydrogen, nitrogen or mixtures of hydrogen and nitrogen with varying amounts of (0—70%) of oxygen and nitrogen-containing gases (up to 1% of oxygen). One batch is treated without any oxygen containing compounds being added to the gas mixture. The flow of gas is lower than in normal sintering. A treatment time at 1400°C of 30 minutes is used.

In a further step the cutting inserts are coated with Al₂O₃ in the same way as in the Comparative Example a.

Examinations in a light microscope and in a scanning electron microscope give results analogous to those in the Comparative Example a. Compared to the results in said Example the amount of binder phase enclosed in the surface zone of (gamma)-phase is still lower.

Tests with hardness indentations give the following results, being added to the results given in the table of Comparative Example b.

| Load | Comparative Example a | Comparative Example b | Comparative Example c |
|------|-----------------------|-----------------------|-----------------------|
| (HRA kg) | | | |
| 60 | 000 | 000 | 000000 |
| 100 | 000 | 010 | 000000 |
| 159 | 100 | 111 | 000000 |

The greater number of tests in Example c is due to the varied partial pressures of oxygen and nitrogen compounds which results in a greater number of samples.

The results show that the concurrent performance of steps (a) and (b), besides facilitating the operating of the process, produce coated products having superior adherence of the oxide layer.

Comparative Example d

300 sintered hard metal cutting inserts are coated with a thin layer of TiC. The composition of the hard metal and the process conditions are the same as those described in Comparative Example a. After that, the gas composition is changed to 10% TiCl₄, 30% N₂ and 60% H₂ and a thin layer of TiN is applied on the TiC-coated bodies. The thickness of the TiC (2 μm)+TiN (3 μm) layer is about 5 μm.

The coated inserts are then heat treated at 1250°—1450°C in a tunnel furnace in an atmosphere of nitrogen+hydrogen for 0.5—3 hours, after which a coating of Al₂O₃ is applied by CVD-technique in a treatment similar to that described in Comparative Example a.

It is found by examinations in microscopes that the diffusion of tungsten and cobalt from the substrate has been effectively prevented by the resulting kind of intermediate layer.

Example 1

One batch of 300 sintered hard metal cutting inserts is heat treated according to the conditions described in Comparative Example c.

All cutting inserts are then coated with successive layers of (TiC+TiN) and a further TiC layer at the conditions mentioned in Comparative Example d. The coating time is shortened, however, so that a total thickness of 0.5—2 μm of the (TiC+TiN) and the further TiC layer is obtained. Finally, a coating of Al₂O₃ is applied to the inserts.

The resulting products from performing steps (a) and (b) concurrently show excellent adherence of the oxide coating.

Claim

Method of treating a cemented carbide substrate containing at least one carbide together with binder metal in order to improve its wear resistance and utility, which method consists of:

(a) treating the substrate in an atmosphere selected from carbide, nitride and carbonitride forming atmospheres to form or apply a coating comprising at least one coat of at least one member selected from the carbides, nitrides and carbonitrides of the elements Ti, Zr, Hf, V, Nb, Ta, Cr, Mo, W, Si and B; a sulfur and/or nitrogen-containing gas being optionally added at the end of or at a period during the treatment to form a sulfide and/or nitride portion on said coating;

(b) heat treating the coated substrate at a temperature greater than the melting point of the binder phase in order to diffuse elements from the substrate into said coating or from the coating into the substrate and optionally treating the resulting substrate with a nitrogen- or sulfur-containing gas; the steps (a)+(b) being performed in one operation; and

(c) applying an aluminium oxide coating on the pre-treated cemented carbide substrate, characterized in that a second coating of at least one member selected from the carbides, nitrides and carbonitrides of the elements Ti, Zr, Hf, V, Nb, Ta, Cr, Mo, W, Si and B is applied to the substrate treated according to the steps (a)+(b) prior to step (c).

**Patentanspruch**

Verfahren zur Behandlung eines gesinterten Carbidsubstrats, das mindestens ein Carbid zusammen mit einem Bindemittelmetall enthält, um seine Abriebfestigkeit und Verwendbarkeit zu verbessern, bei dem man:

(a) das Substrat in einer Atmosphäre, die unter Carbid, Nitrid oder Carbonitridbildenden Atmosphären ausgewählt ist, zur Bildung oder zum Aufbringen eines Uebegzugs behandelt, der aus mindestens einer Schicht mindestens einer unter den Carbiden, Nitriden und Carbonitriden der Elemente Ti, Zr, Hf, V, Nb, Ta, Cr, Mo, W, Si und B ausgewählten Komponente besteht, wobei gegebenenfalls am Ende oder für einen Zeitraum während der Behandlung zur Bildung eines Sulfid- und/oder Nitridanteils in diesem Ueberzug ein schwefel- und/oder stickstoffhaltiges Gas zugesetzt wird,

(b) das beschichtete Substrat bei einer höheren Temparatur als dem Schmelzpunkt der Bindemittelphase wärmebehandelt, um Elemente aus dem Substrat in diesen Ueberzug oder aus dem Ueberzug in das Substrat diffundieren zu lassen, und gegebenenfalls das so erhaltene Substrat mit einem stickstoff= oder schwefelhaltigen Gas behandelt, wobei die Stufen (a) und (b) in einem Arbeitsgang erfolgen, und

(c) auf dem vorbehandelten gesinterten Carbidsubstrat einen Aluminiumoxydüberzug aufbringt, dadurch gekennzeichnet, dass man auf das gemäss Stufen (a)+(b) behandelte Substrat vor der Stufe (c) einen zweiten Ueberzug mindestens einer unter den Carbiden, Nitriden und Carbonitriden der Elemente Ti, Zr, Hf, V, Nb, Ta, Cr, Mo, W, Si und B ausgewählten Komponente aufbringt.

**Revendication**

Procédé de traitement d'un substrat en carbure fritté contenant au moins un carbure et un métal liant pour améliorer sa résistance à l'usure et son utilité, ledit procédé comportant les phases consistant à:

(a) traiter le substrat dans une atmosphère sélectionnée parmi des atmosphères de formation de carbure, nitrure et carbonitrure pour former ou appliquer un revêtement comportant au moins une couche d'au moins un produit sélectionné parmi les carbures, nitrures et carbonitrures des éléments Ti, Zr, Hf, V, Nb, Ta, Cr, Mo, W, Si et B; un gaz contenant du soufre et/ou de l'azote pouvant être ajouté à la fin ou à un instant du traitement pour former une partie en sulfure et/ou nitrure sur ledit revêtement;

(b) traiter thermiquement le substrat revêtu à une température supérieure au point de fusion de la phase de liant pour faire diffuser des éléments à partir du substrat dans ledit revêtement ou à partir du revêtement dans le substrat et, le cas échéant, traiter le substrat résultant avec un gaz contenant de l'azote ou du soufre; les phases (a) et (b) étant effectuées en une opération; et

(c) appliquer un revêtement d'oxyde d'aluminium sur le substrat en carbure fritté pré-traité;

caractérisé en ce qu'un second revêtement d'au moins un produit choisi parmi les carbures, nitrures et carbonitrures des éléments Ti, Zr, Hf, V, Nb, Ta, Cr, Mo, W, Si et B est appliqué au substrat traité conformément aux phases (a) et (b) avant la phase (c).